# EUROPÄISCHE PATENTANMELDUNG

(11) **EP 1 605 077 A2**
(43) Veröffentlichungstag der Anmeldung: **14.12.2005**
(21) Anmeldenummer: 05012298.5
(22) Anmeldetag: 08.06.2005
(51) Int. Cl.: C23C 16/54, C23C 16/50

(54) **Verfahren und Vorrichtung zum Behandeln von Substraten in einer Rundläuferanlage**

(30) Priorität: 11.06.2004 DE 102004028369
(71) Anmelder: Schott AG, 55122 Mainz (DE)
(72) Erfinder: Bicker, Matthias Dr., 55126 Mainz (DE); Behle, Stephan Dr., 55239 Gau-Odernheim (DE); Lüttrinhaus-Henkel, Andreas, 64289 Darmstadt (DE); Arnold, Gregor, 55294 Bodenheim (DE); Klein, Jürgen Dr., 55127 Mainz (DE)
(74) Vertreter: Herden, Andreas F.

(57) **Zusammenfassung**

Die Erfindung betrifft ein Verfahren und eine Vorrichtung zum Behandeln von Substraten, insbesondere zum Beschichten von Kunststoffbehältern auf einer Rundläuferanlage.

Auf dem Rundläufer sind mehrere Behandlungseinrichtungen, die mehrere Prozessphasen in Abhängigkeit von ihrer Winkelposition auf dem Rundläufer durchlaufen. Für zumindest eine Prozessphase ist die Winkelposition in Abhängigkeit von der aktuellen Drehgeschwindigkeit des Rundläufers variabel einstellbar.

## Beschreibung

Die Erfindung betrifft ein Verfahren und eine Vorrichtung zum Behandeln von Substraten in einer Rundläuferanlage, insbesondere zur gleichmäßigen Barrierebeschichtung von Kunststoff-Behältern in einer Rundläuferanlage.

Die Beschichtungsprozesse für Massenprodukte, wie beispielsweise Lebensmittel- oder Pharmaverpackungen, Kunststoff-Getränkeflaschen etc. erfordern bei industriellen Fertigungen hohe Durchsätze mit hoher Beschichtungsqualität.

Die dafür immer häufiger zur Anwendung kommenden Kunststoffe weisen dazu Barrierebeschichtungen auf, um deren Durchlässigkeit für Gase und Flüssigkeiten herabsetzen zu können, sowie diese gegen chemische Angriffe oder UV-Strahlung zu schützen. Hierbei ist beispielsweise das Abscheiden dünner SiOₓ-Beschichtungen oder - Beschichtungssysteme auf Polymersubstraten interessant, um deren Durchlässigkeit vor allem für Sauerstoff und Wasserdampf zu reduzieren und insbesondere dabei gleichzeitig die Transparenz des Materials zu erhalten.

Derartige Beschichtungen sind ggf. auch auf Glasbehältern oder Glassubstraten, beispielsweise im Bereich von Pharmaverpackungen, sinnvoll um die Migration von AlkaliIonen aus dem Glas zu verhindern.

Als besonders effektive und kostengünstige Technologie zur Beschichtung von Substraten erweist sich dabei das CVD Verfahren (chemische Dampfphasenabscheidung), mit dem sich sehr dünne und gleichmäßige Schichten aus vielfältigen Gasgemischen erzeugen lassen.

Insbesondere mittels Plasma-Impuls-CVD Verfahren lassen sich im allgemeinen sehr dünne gleichmäßige Schichten unter geringer Temperaturbelastung herstellen, so dass diese insbesondere für Kunststoffsubstrate geeignet sind. Ein weiterer Vorteil der gepulsten plasmaunterstützten Verfahren besteht darin, dass beispielsweise sehr reine anorganische Barriereschichten hergestellt werden können, da hier im Gegensatz zu den Verfahren mit ungepulster Plasma-Anregung unerwünschte organische Reaktionsprodukte in der Pulspause entfernt werden können und somit ein deutlich geringerer Anteil an organischen Bestandteilen in den Schichten eingebaut wird.

Für eine wirtschaftliche Umsetzung eines Beschichtungsprozesses auf Substrate, wie z.B. einer Barrierebeschichtung auf PET-Flaschen, ist es notwendig sehr hohe Probendurchsätze zu realisieren. Typische geforderte Probendurchsätze liegen bei ca. 10.000 Flaschen pro Stunde.

Um die geforderten hohen Durchsätze realisieren zu können kommen u.a. Rundläuferanlagen zur Anwendung, bei denen mehrere Beschichtungsstationen für die zu beschichtetenden Produkte auf einer kreisförmigen Bahn umlaufen. Dabei sind den einzelnen Prozessphasen während eines Umlaufs bestimmte Kreissegmente oder Winkelbereiche zugeordnet.

Eine solche Vorrichtung ist beispielsweise aus der WO 00/58631 bekannt, bei welcher 20 identische Behandlungsstationen auf einem Förderkarussell angeordnet sind. Durch die Verteileranordnung mit vorgegebener Öffnungsanordnung ist festgelegt, in welchem Sektor des Rundläufers eine bestimmte Prozessphase in einer Behandlungsstation erfolgt. Die Verteileranordnung besteht aus zwei koaxialen Kränzen, einem feststehenden und einem rotierenden Kranz. Der rotierende Kranz enthält Öffnungen, die jeweils an eine Behandlungsstation angeschlossen sind. Der feststehende Kranz weist Schlitze auf, auf deren Bahn sich jeweils eine Reihe von Öffnungen des rotierenden Kranzes befinden, so dass eine Behandlungsstation winkelbezogen die Prozessphasen durchläuft. Damit ist keinerlei Variation des Prozessablaufes möglich.

Das wirkt sich vor allem bei Störungen und Schwankungen im Prozessablauf negativ aus, da auf diese nicht flexibel reagiert werden kann und diese eine Verminderung der Qualität der Beschichtung zur Folge haben.

Die Erfindung hat sich daher die Aufgabe gestellt, die Behandlung von Substraten, insbesondere die Beschichtung von Substraten mit hohen Durchsatzraten stabil und zuverlässig mit den geforderten Qualitätsparametern der behandelten Substrate, insbesondere der Beschichtung, zu realisieren.

Die Lösung der Aufgabe gelingt mit einem Verfahren gemäß des unabhängigen Anspruchs 1 und einer Vorrichtung gemäß des unabhängigen Anspruchs 19. Vorteilhafte Weiterbildungen der Erfindung sind in den Unteransprüchen ausgeführt.

Erfindungsgemäß werden in mehreren, auf einem Rundläufer befindlichen Behandlungseinrichtungen während einer Umdrehung des Rundläufers eine Mehrzahl von Prozessphasen eines Behandlungszyklus durchlaufen, wobei die Steuerung der Prozeßphasen in einer Behandlungseinrichtung in Abhängigkeit von deren Winkelposition erfolgt und zumindest ein Winkelabschnitt einer Prozessphase in Abhängigkeit von der aktuellen Drehgeschwindigkeit des Rundläufers innerhalb eines vorgegebenen Winkelabschnittes, der für eine maximale Drehgeschwindigkeit definiert ist, eingestellt wird. Ein Behandlungszyklus umfasst zumindest die folgenden Prozessphasen:
- Einbringen zumindest eines Substrates in eine Behandlungseinrichtung,
- Behandeln zumindest eines Substrates in einer Behandlungseinrichtung und
- Entfernen der/des behandelten Substrates aus der Behandlungseinrichtung.

Die erfindungsgemäße Vorrichtung zum Behandeln von Substraten weist mehrere, auf einem Rundläufer befindliche Behandlungseinrichtungen auf, welche eine Mehrzahl von Frozessphasen eines Behandlungszykluses während einer Umdrehung des Rundläufers durchlaufen, wobei jeder Prozessphase ein Winkelbereich des Rundläufers zugeordnet ist und der Rundläufer zumindest folgende Winkelbereiche umfasst:
- Bereich zum Einbringen zumindest eines Substrates in eine Behandlungseinrichtung,
- Bereich zum Behandeln zumindest eines Substrates in einer Behandlungseinrichtung und
- Bereich zum Entfernen der/des behandelten Substrates aus der Behandlungseinrichtung,
und weist ausserdem eine Steuereinrichtung zum Einstellen zumindest eines Winkelabschnittes in Abhängigkeit von der aktuellen Drehgeschwindigkeit des Rundläufers innerhalb des vorgegebenen Winkelbereiches auf, der für eine maximale Drehgeschwindigkeit definiert ist.

Insbesondere kann der Winkelabschnitt einer Prozessphase in Abhängigkeit von der aktuellen Drehgeschwindigkeit des Rundläufers vorzugsweise so eingestellt werden, dass er vollständig von dem jeweiligen vorgegebenen Winkelabschnitt überdeckt wird, der für eine maximale Drehgeschwindigkeit definiert ist. Dies ist insbesondere bei mehreren derartig eingestellten Prozessphasen beispielsweise gegenüber einer zeitlichen Steuerung von Vorteil. Wird eine zeitliche Steuerung mehrerer aufeinanderfolgender Prozessphasen vorgenommen, die in vorgegebener zeitlicher Reihenfolge nacheinander ausgeführt werden, so verschiebt sich spätestens die zweite zeitlich gesteuerte Prozessphase dann so, dass sie nicht mehr vollständig innerhalb eines bei Maximalgeschwindigkeit gegebenen Winkelabschnitts liegt, sondern diesen allenfalls noch teilweise überdeckt. Dies kann sich jedoch sehr nachteilig auf das erwünschte Beschichtungsergebnis und auf den gesamten Prozessablauf sein. Beispielsweise würden fest angeordnete Sensoren den Zustand der Reaktoren oder der Werkstücke dann drehzahlabhängig zu verschiedenen Behandlungszeitpunkten erfassen. Demgegenüber bleibt erfindungsgemäß die Zuordnung einer bestimmten Behandlungsphase zu definierten Winkelabschnitten erhalten.

Dies kann auch erreicht werden, wenn die Winkelabschnitte mehrerer aufeinanderfolgender Prozessphasen bei nicht maximaler Drehgeschwindigkeit durch die Steuereinrichtung so eingestellt werden, dass zwischen diesen Phasen eine Leerphase entsteht. Dabei wird jedoch nicht ausgeschlossen, dass eine oder mehrere weitere Prozessphasen während der Leerphase weiterlaufen. Beispielsweise kann zwischen zwei Beschichtungsschritten, in welchen ein Plasma gezündet wird, in einer Leerphase zwischen diesen beiden Prozessen weiterhin Prozessgas zugeführt und/oder evakuiert werden.

Gemäß einer bevorzugten Ausführungsform der Erfindung umfasst die Prozessphase der Behandlung des Substrates eine Plasmabehandlung des Substrates, insbesondere eine Plasmabeschichtung mit den Prozessphasen:
- Evakuierung der für eine Beschichtung erforderlichen Räume in der Behandlungseinrichtung,
- Zuführen von Prozessgas und
- Zünden eines Plasmas, wobei eine Beschichtung des Substrates erfolgt.
Ein Behandlungszyklus kann dabei auch mehrere Beschichtungsvorgänge mit unterschiedlichen Beschichtungen umfassen. Ein Rundläufer umfasst dann diesen Phasen zugeordnete Winkelabschnitte.

Vorzugsweise erfolgt die Einstellung des Winkelabschnittes der Prozessphase - "*Zünden eines Plasmas*" - in Abhängigkeit von der aktuellen Drehgeschwindigkeit des Rundläufers innerhalb des Winkelabschnittes der Prozessphase - *"Zuführen von Prozessgas*". Dazu wird dem Rundläufer ein Winkelabschnitt für die Prozessphase - "*Zuführen von Prozessgas*" - fest zugeordnet, wobei dieser unabhängig von der Drehgeschwindigkeit der Anlage eingestellt ist. Will man für jeden Beschichtungsvorgang gleiche Schichtdicken erzeugen, sollte jeder Beschichtungsvorgang unter gleichen Prozessparametern stattfinden. So ist bei sonst annähernd konstanten Prozessbedingungen auch die Beschichtungszeit konstant zu halten. Bei einer Prozesssteuerung lediglich in Abhängigkeit von der Winkelposition ist das nur bei sehr konstanter Drehgeschwindigkeit des Rundläufers möglich. Prozess- und produktionsbedingt kommt es aber häufiger zu Verzögerungen oder sogar zu Stockungen oder anders verursachten Staus im Prozessablauf, so dass eine Maschine mit fest eingestellter konstanter Drehgeschwindigkeit häufig gestoppt werden muss. Z.B. können Verzögerungen dadurch entstehen, dass andere Maschinen innerhalb der Prozesslinie, wie z.B. die Blasmaschine, der Füller oder der Palettierer kurz gestoppt werden müssen oder nur mit reduziertem Durchsatz arbeiten können.

Bei der erfindungsgemäßen drehzahlunabhängigen ProzessSteuerung kann in vielen Fällen dagegen ein zeitweiliger Stillstand der Beschichtungsanlage verhindert werden. Somit wird eine effizientere Produktion im kontinuierlichen Betrieb möglich.

Kommt es zu einer solchen Verlangsamung, wird in Abhängigkeit von der aktuellen Drehgeschwindigkeit ein Winkelabschnitt eingestellt, welcher eine gleichbleibende Beschichtungszeit gewährleistet.

Günstig dabei ist es, nicht die Zufuhr von Prozessgas zu unterbrechen oder zu variieren, da dies Schwankungen von stationär eingestellten Prozessbedingungen nach sich ziehen würde, sondern lediglich den Zeitpunkt der Zündung des Plasmas zu variieren. So wird beispielsweise lediglich der Winkelabschnitt für die Prozessphase - "*Zünden* eines Plasmas" - in Abhängigkeit von der aktuellen Drehgeschwindigkeit eingestellt, vorzugsweise derart, dass die Winkelposition für das Ende der Prozessphase - *"Zünden* eines *Plasmas*" - für zumindest den letzten Beschichtungsvorgang eines Behandlungszyklus der Winkelposition für das Ende der Prozessphase - "Zuführen von Prozessgas" - entspricht. Damit wird gleichzeitig sichergestellt, dass das Plasma zumindest im letzten Beschichtungsvorgang vollständig umgesetzt wird und keine unerwünschten Prozessgase im beschichteten Behälter zurückbleiben. Für die Beschichtung von Lebensmittel- oder Pharmaverpackungen ist es zwingend notwendig, die Behälter frei von unverbrauchten Prozessgasen zu halten. Diese Forderung wird durch den in der vorliegenden Erfindung beschriebenen Prozessablauf auf überraschend einfache Weise gelöst.

In einer weiteren bevorzugten Ausführungsform der Erfindung umfasst das Verfahren die Beschichtung von KunststoffHohlkörpern mit einer Barriereschicht von innen und/oder außen. Dazu werden in einem Behandlungszyklus zumindest die folgenden Prozessphasen durchlaufen:
- Einbringen zumindest eines Hohlkörpers in eine Behandlungseinrichtung,
- Evakuierung der Behandlungseinrichtung im Bereich des Außenraumes des Hohlkörpers bis zu einem ersten Druckwert,
- Evakuierung des Innenraumes des Hohlkörpers bis zu einem zweiten Druckwert, welche niedriger ist als der erste Druckwert,
- Zuführen eines ersten Prozessgases für eine Haftvermittlerschicht,
- Zünden eines Plasmas, wobei die Beschichtung des Hohlkörpers mit einer Haftvermittlerschicht erfolgt,
- Zuführen eines zweiten Prozessgases für eine Barriereschicht,
- Zünden eines Plasmas, wobei die Beschichtung des Hohlkörpers mit einer Barriereschicht erfolgt,
- Belüften der Behandlungseinrichtung und des Hohlkörpers und
- Entfernen der/des beschichteten Hohlkörpers aus der Behandlungseinrichtung.
   Ein Rundläufer einer erfindungsgemäßen Vorrichtung weist dann den entsprechenden Prozessphasen zugeordnete Winkelbereiche auf.

Zusätzlich zu der vorbeschriebenen Einstellung der Winkelabschnitte kann hier außerdem die Winkelposition zum Start der Prozessphase - "Evakuierung des *Innenraumes des* Hohlkörpers bis zu einem zweiten Druckwert" - in Abhängigkeit von der aktuellen Drehgeschwindigkeit des Rundläufers variabel zur Winkelposition zum Start der Prozessphase - "*Evakuierung der Behandlungseinrichtung im Bereich des Außenraumes des Hohlkörpers bis zu einem ersten Druckwert" -* eingestellt werden, so dass eine feste Verzögerungszeit zwischen diesen Prozessphasen realisiert wird. Somit wird, unabhängig von Schwankungen der Drehgeschwindigkeit des Rundläufers, sichergestellt, dass die Druckdifferenz zwischen dem Druck im Innenraum des Hohlkörpers und dem Druck in der Behandlungskammer gleich bleibt und die Prozessparameter für die Beschichtung stabil gehalten werden.

Sind alle Behandlungseinrichtungen über Verteilerleitungen mit zumindest einer gemeinsamen Pumpeinrichtung verbunden, kann die Pumpeneinrichtung fest mit den Behandlungseinrichtungen verbunden sein und ein erhöhter Durchsatz realisiert werden. Die Pumpeinrichtung kann bei dieser Ausführung auf dem Rundläufer mitrotieren und ein aufwendiger und schwierig abzudichtender rotierender Anschluss oder eine pumpenseitige Drehschieberdurchführung kann entfallen.

Eine Steuerung der Evakuierung der einzelnen Behandlungseinrichtungen, wie zuvor beschrieben, erfolgt über eine Steuereinrichtung, welche die entsprechende Zuordnung zwischen der Pumpeinrichtung und den einzelnen Behandlungseinrichtungen entsprechend der aktuellen Prozessphase mittels der in den Verteilerleitungen angeordneten Ventile steuert.

Vorzugsweise erfolgt die Evakuierung der Behandlungseinrichtungen während der entsprechenden Prozessphasen mit einer gemeinsamen Pumpeinrichtungen und die Evakuierung der Hohlkörper mit einer weiteren gemeinsamen Pumpeinrichtungen, wobei beide Pumpeinrichtungen unabhängig voneinander steuerbar sind.

Jede gemeinsame Pumpeinrichtung kann mehrere Pumpen mit unterschiedlichen Druckbereichen umfassen, mit denen eine kaskadierte oder stufenweise Evakuierung der Behandlungseinrichtung bzw. Hohlkörper einfach umzusetzen ist.

In einer weiteren bevorzugten Ausführungsform wird den Behandlungseinrichtungen mittels zumindest einer gemeinsamen Prozessgasversorgungseinrichtung das Prozessgas während der entsprechenden Prozessphasen zugeführt, wobei die Verbindung der Prozessgasversorgungseinrichtung mit den einzelnen Behandlungsstationen über Verteilerleitungen hergestellt wird und die Prozessgaszufuhr zu den einzelnen Behandlungsstationen über Ventile gesteuert wird.

Bei Verwendung verschiedener Prozessgase, wie dies beispielsweise bei einer Barrierebeschichtung von Kunststoffhohlkörpern mit einem Haftvermittler-Barriere-Schichtverbund der Fall ist, wird jedes Prozessgas mit jeweils einer gesonderten gemeinsamen Prozessgasversorgungseinrichtung zugeführt. Die Prozessgasversorgungseinrichtungen enthalten beispielsweise die Grundstoffe zur Erzeugung der Beschichtungen oder weitere, für den Prozess notwendige Gase.

Die Beschichtung erfolgt in einer bevorzugten Ausführung der Erfindung mittels plasmaunterstützter Dampfphasenabscheidung, durch das Zünden eines Plasmas mittels Mikrowellenenergie, vorzugsweise mittels gepulster Mikrowellenenergie.

Bevorzugt durchläuft jedes Substrat den gleichen Behandlungszyklus, so dass im kontinuierlichen Verfahrensablauf permanent jede Behandlungseinrichtung zumindest ein Substrat enthält und eine Prozessphase durchläuft, wobei jede Behandlungseinrichtung alle Prozessphasen durchläuft und eine Behandlungseinrichtung in die Prozessphase oder Prozessphasen einer vorgeordneten Behandlungseinrichtung wechselt.

Bei Rundläuferanlagen mit gemeinsamen Pumpeinrichtungen und/oder gemeinsamen Prozessversorgungseinrichtungen bestehen beim Start der Anlage noch keine definierten Prozessbedingungen, da sich erst nach dem Durchlaufen aller Behandlungseinrichtungen durch alle Professphasen definierte Druck- und Flussverhältnisse in den Verteilerleitungen und Behandlungskammern eingestellt haben. Um eine Beschichtung ungenügender Qualität zu vermeiden ist vorzugsweise vor dem Einbringen der ersten Substrate in eine Behandlungseinrichtung beim Starten eines kontinuierlichen Verfahrensablaufes jede Behandlungseinrichtung ohne Substrat durch jede Prozessphase zumindest einmal zu führen. Dabei entfällt die Zündung des Plasmas, um keinen Beschichtungsprozess in der Behandlungskammer hervorzurufen. Typischerweise werden mindestens zwei bis drei Umläufe benötigt, um stabile Prozessbedingungen, d.h. stabile Drücke und Flüsse in allen Kammern einzustellen.

Diese Vorgehensweise ist auch bei Störungen anwendbar, beispielsweise, wenn die Anlage nicht kontinuierlich mit Substraten versorgt werden kann. In diesem Fall durchlaufen die Behandlungseinrichtungen leer die jeweils anstehenden Prozessphasen, wobei hier die Zündung des Plasmas unterdrückt wird. Damit wird der Gesamtprozess nicht unterbrochen und die Druck-Fluss-Verhältnisse in der Anlage konstant gehalten.

Im folgenden wird die Erfindung anhand eines Ausführungsbeispieles und unter Bezugnahme auf die Zeichnungen näher erläutert. Es zeigen dazu:
- Fig. 1: eine schematische Darstellung des Prozessablaufes mit zugeordneten Winkelabschnitten des Rundläufers
- Fig.2: eine schematische Darstellung einer beispielhaften Vorrichtung

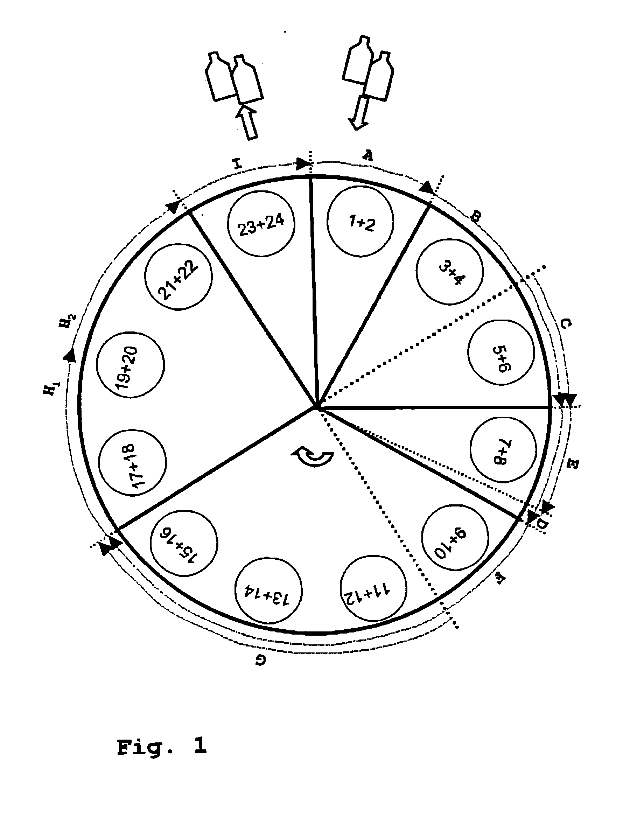

Die in Fig. 1 gezeigte schematische Darstellung des Prozessablaufes einer Beschichtung von Hohlkörpern (1,2,...,24) zeigt die einzelnen Prozessphasen (A,B,...,I) und die entsprechenden Winkelabschnitte auf dem Rundläufer. Dabei sind Winkelabschnitte mit durchgezogenen Linien festgelegte Winkelabschnitte. Die Winkelabschnitte mit unterbrochenen Linien sind in Abhängigkeit von der aktuellen Drehgeschwindigkeit des Rundläufers variabel einstellbar. Auf dem Rundläufer sind zwölf gleiche Behandlungsstationen (101,102,...,112) in gleichmäßigen Abständen von 30° angeordnet. Jede Behandlungsstation (101,102,.,.,112) durchläuft den gesamten Behandlungszyklus mit den Prozessphasen (A,B,...,I) und die entsprechend zugeordneten Winkelabschnitte:
■ Einbringen der Hohlkörper (A),
■ Evakuierung der Behandlungseinrichtung im Bereich des Außenraumes des Hohlkörpers(B),
■ Evakuierung des Innenraums der Hohlkörper (C),
■ Zuführen Prozessgas Haftvermittler (D)
■ Zünden Plasma Haftvermittler (E),
■ Zuführen Prozessgas Barriereschicht (F),
■ Zünden Plasma Barriereschicht (G),
■ Belüften des Innenraums der Hohlkörper (H1)
■ Belüften der Behandlungseinrichtung (H2) und
■ Entfernen der Hohlkörper (I)

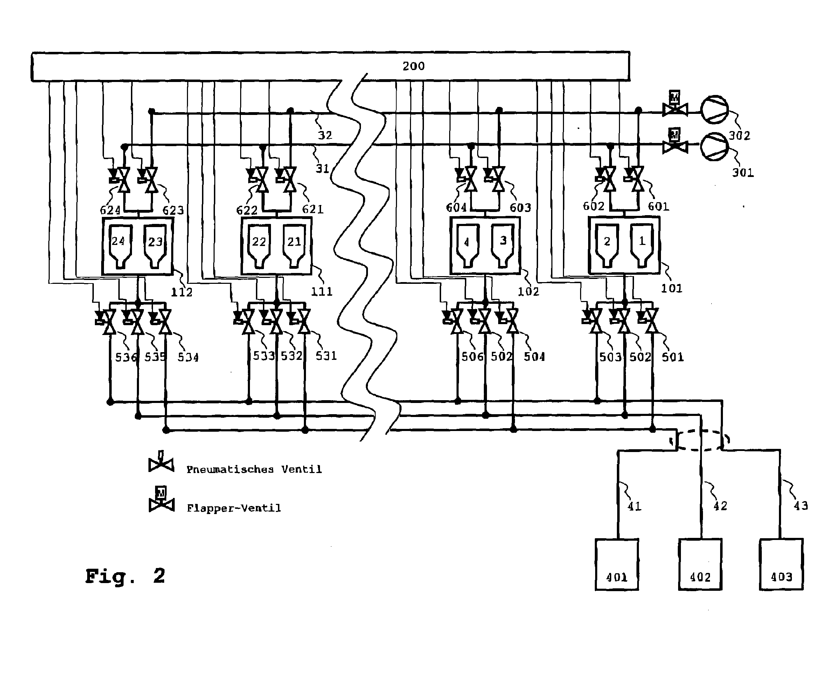

Fig. 2 zeigt eine schematische Darstellung einer Rundläuferanlage zum Beschichten von Hohlkörpern (1,2,...,24) mittels der in Fig.1 dargestellten Anordnung von zwölf Behandlungseinrichtungen (101,102,...,112) und dem in Fig.1 dargestellten Behandlungszyklus.

Jede auf dem Rundläufer (in Fig. 2 nicht dargestellt) befindliche Behandlungseinrichtung (101,102,...,112) kann zwei Hohlkörper (1,2,...,24), insbesondere PET-Flaschen zur Beschichtung, insbesondere zur Innenbeschichtung mit einer Barriereschicht, aufnehmen. Die Aufnahme von zwei Substraten je Behandlungseinrichtung (101,102....,112) ist nur beispielhaft und eine andere Anzahl ebenso realisierbar.

Auf dem Rundläufer sind außerdem die erste gemeinsame Pumpeinrichtung (301), welche über die Verteilerleitung (31) mit jeder Behandlungseinrichtung (101,102,...,112) verbunden ist und die zweite gemeinsame Pumpeinrichtung (302), welche über die Verteilerleitung (32) mit jeder Behandlungseinrichtung (101,102,...112) verbunden ist, angeordnet und können somit auf dem Rundläufer mitrotieren.

Die Verteilerleitungen (31,32) weisen Ventile (601,602,...,624) auf, die jeweils die Verbindung jeder Pumpeinrichtung (301,302) mit jeder Behandlungseinrichtung (101,102,...,112) separat und in Abhängigkeit von der jeweiligen Prozessphase (A,B,...,I) steuern. Die Ventile (601,602,...,624) sind durch die Steuereinrichtung (200) einzeln steuerbar.

Die Pumpeinrichtungen (301,302) können mehrere Pumpstufen umfassen, die unterschiedlichen Druckbereichen zugeordnet sind. Die Pumpstufen können durch eine Pumpe, z.B. durch eine Rootspumpe, mit einer Verteilerleitung, wie im Ausführungsbeispiel Fig. 2 dargestellt oder durch mehrere Pumpen mit mehreren separaten Verteilerleitungen realisiert werden.

Die Prozessgasversorgungseinrichtungen (401,402,403) sind stationär in der Rundläuferanlage angeordnet, so dass die Versorgungsbehälter mit den Grundstoffen gewechselt werden können, ohne den Rundläufer anzuhalten.

Die Prozessgasversorgungseinrichtungen (401) für den Haftvermittler ist über die Verteilerleitung (41) mit jeder Behandlungseinrichtung (101,102,...,112) verbunden.
Die Prozessgasversorgungseinrichtung (402) für die Barriereschicht ist über die Verteilerleitung (42) mit jeder Behandlungseinrichtung (101,102,...,112) verbunden und die Prozessgasversorgungseinrichtung (403) für das Spülgas ist über die Verteilerleitung (43) mit jeder Behandlungseinrichtung (101,102,...112) verbunden.
Die Verteilerleitungen (41,42,43) weisen Ventile (501,502,...,536) auf, die jeweils die Verbindung jeder Prozessgasversorgungseinrichtungen (401,402,403) mit jeder Behandlungseinrichtung (101,102,...,112) separat und in Abhängigkeit von der jeweiligen Prozessphase (A,B,...,I) steuern. Die Ventile (501,502,...,536) sind durch die Steuereinrichtung (200) einzeln steuerbar. Die Verteilerleitungen (41,42,43) sind mittels drehbaren dichtenden Anschlüssen mit den stationären Prozessgasversorgungseinrichtungen (401,402,403) verbunden.

Die Prozessgasversorgungseinrichtungen für den Haftvermittler (401) stellt ein Gasgemisch aus Hexamethyldisiloxan (HMDSO) und Sauerstoff bereit, welches bei Zündung eines Plasmas eine SiOₓC_{y}-Haftvermittlerschicht bildet.

Die Prozessgasversorgungseinrichtungen für die eigentliche Barriereschicht (402) stellt ein Gasgemisch aus Hexamethyldisilazan (HMDSN) und Sauerstoff bereit, welches bei Zündung eines Plasmas eine transparente SiOₓ-Barriereschicht bildet.
Als alternative technische Lösungen kann aber auch ein Gasgemisch aus Hexamethyldisiloxan (HMDSO) und Sauerstoff für die Herstellung der Barriereschicht verwendet werden. Auch eine Herstellung einer Haftvermittler- und oder Barriereschicht aus amorphem Kohlenstoff mittel Kohlenwasserstoff-Gas oder einem Gemisch von Kohlenwasserstoff mit einer der zuvor genannten Gase wäre eine weitere Lösung. Zusätzlich kann auch einem der zuvor genannten Gasgemische ein stickstoffhaltiges Gas beigemischt werden.

Die Prozessgasversorgungseinrichtungen (403) stellt ein Spülgas, beispielsweise Sauerstoff, Stickstoff und/oder getrocknete Luft bereit um in der Belüftungsphase unverbrauchtes Gas zu entfernen und ist für den Gesamtprozess optional.

Jede Behandlungseinrichtung (101,102,...,112) weist einen Reaktor mit zwei Behandlungsplätzen auf, wobei ebenso die Möglichkeit besteht, jede Behandlungseinrichtung (101,102,...,112) mit zwei Reaktoren auszustatten. Zur Zündung eines Plasmas und Realisierung eines gepulsten plasmaunterstützten CVD-Prozesses wird in die Reaktoren gepulste Mikrowellenenergie eingekoppelt. Dazu ist jeder Behandlungseinrichtung (101,102,...112) eine Hochfrequenzquelle zugeordnet, die das Plasma im Reaktor bzw. in den beiden Reaktoren gleichzeitig zündet.

### Startphase:

Nach Prozessunterbrechungen aus den unterschiedlichsten Gründen soll die Beschichtung der PET-Flaschen erneut begonnen werden. Die Behandlungseinrichtungen (101,102,...,112) sind zu diesem Zeitpunkt leer.

Vor dem Einbringen der ersten beiden Hohlkörper (1,2) in die erste Behandlungseinrichtung (101) werden die Prozessgase für den Haftvermittler, für die Barrierebeschichtung und das Spülgas aus den Prozessgasversorgungseinrichtungen (401,402,403) über die entsprechenden Verteilerleitungen (41,42,43) den Behandlungseinrichtungen (101,102,...112) zugeführt und die beiden Pumpeinrichtungen (301,302) zugeschaltet. Dazu durchlaufen die leeren Behandlungseinrichtungen (101,102,...,112) zumindest einmal die Prozessphasen (A,B,...,I), wobei kein Plasma gezündet wird, Die Zuführung der Prozessgase und das Zuschalten der beiden Pumpeinrichtungen (301,302) erfolgt analog zum vorgegebenen Behandlungszyklus und den entsprechenden festgelegten und steuerbaren Winkelabschnitten gemäß Fig. 1. In den Behandlungseinrichtungen (101,102,...112) entsteht dadurch ein stationäres Druck-Fluss-Gleichgewicht.

Nach der Einstellung eines stationäres Druck-Fluss-Gleichgewichtes werden die ersten beiden Hohlkörper (1,2) der ersten Behandlungseinrichtung (101) zugeführt. Als erste Behandlungseinrichtung (101) wird diejenige definiert, die sich bei der Zuführung der ersten beiden Hohlkörper (1,2) im Winkelbereich der Prozessphase - *"Einbringen der Hohlkörper* (A)" - befindet.

Hat die erste Behandlungseinrichtung (101) mit den beiden Hohlkörpern (1,2) erstmalig alle Prozessphasen (A,B,...,I) durchlaufen, befinden sich -einen kontinuierlichen Ablauf vorausgesetzt- in jeder der Behandlungseinrichtung innerhalb der Phasen B bis H2 zwei Hohlkörper und es durchläuft im weiteren kontinuierlichen Prozessablauf jede Behandlungseinrichtung (101,102,...,112) mit je zwei Hohlkörpern (1,2,...,24) alle Prozessphasen (A,B,...,I) entsprechend den vorgegebenen und einstellbaren Winkelbereichen.

### kontinuierlicher Ablauf der Prozessphasen:

Im weiteren wird der kontinuierliche Ablauf der Prozessphasen an Hand der ersten Behandlungseinrichtung (101) erläutert. Wie Fig. 1 zu entnehmen ist, durchlaufen alle Behandlungseinrichtungen (101,102,...,112) im Abstand von 30° nacheinander alle Phasen.

Durchläuft die Behandlungseinrichtung (101) den fest eingestellten Winkelabschnitt von 30° der Prozessphase - "Einbringen *der Hohlkörper* (A)" - werden in einer Zeit T_{A}, die abhängig von der aktuellen Drehgeschwindigkeit des Rundläufers ist, zwei Hohlkörper (1,2) in die Behandlungseinrichtung (101) eingebracht.

Innerhalb des fest eingestellten Winkelabschnittes von 60° für die Prozessphase -"*Evakuierung der Behandlungseinrichtung* (B)"- ist der Winkelabschnitt für die Prozessphase -"*Evakuierung der Hohlkörper* (C)"- in Abhängigkeit von der aktuellen Drehgeschwindigkeit des Rundläufers einstellbar. Zwischen den beiden Prozessphasen (B,C) soll eine feste Verzögerungszeit T_{VER} realisiert werden, um eine unabhängig von der Drehgeschwindigkeit der Maschine gleichbleibende Druckdifferenz zwischen KörperHohlraum und -Außenraum zu erzeugen. Dazu wird das Ventil (601), welches die Evakuierung der Behandlungseinrichtung (101) steuert zu Beginn der Prozessphase -"*Evakuierung* der *Behandlungseinrichtung* (B)"- geöffnet und der Außenraum der Behandlungseinrichtung (101) in einer Zeit T_{EB}, die konstant und damit unabhängig von der aktuellen Drehgeschwindigkeit des Rundläufers ist, evakuiert. Gleichzeitig wird über die Steuereinrichtung (200) ein Winkelabschnitt für die Prozessphase - *"Evakuierung* des Innenraums der *Hohlkörper* (C)"- in Abhängigkeit von der aktuellen Drehgeschwindigkeit des Rundläufers ermittelt, der einer Zeit T_{EH} entspricht mit T_{EB}-T_{EH}=T_{VER}= konst., damit eine konstante Verzögerungszeit T_{VER} eingestellt werden kann. Das Ventil (601), welches die Evakuierung des Hohlkörpers steuert, wird entsprechend verzögert geöffnet. Somit wird unabhängig von der Drehgeschwindigkeit der Maschine verhindert, dass die Flaschen durch zu hohe Druckdifferenzen verformt werden und es wird ein gleiches Druckniveau für den Basisdruck erreicht'.

An die Evakuierung schließt sich der erste Beschichtungsprozess an, welcher die Prozessphasen - *"Zuführen Prozessgas Haftvermittler* (D)"- und -"*Zünden Plasma Haftvermittler* (E)"- umfasst. Dabei wird eine konstante Verzögerungszeit t_{verz} zwischen dem Gaseinlass und dem Zünden des Plasma verwendet. Im Normalfall, bei völlig konstanten Prozessparametern, könnten ab dem Zünden des Plasmas diese beiden Phasen völlig parallel ablaufen und über einen Winkelabschnitt von beispielsweise 25° könnte das Plasma fest eingestellt brennen. Durch Verzögerungen im Prozessablauf oder andere Störungen kommt es jedoch oftmals zu einer Verlangsamung der Drehgeschwindigkeit des Rundläufers, so dass bei einem festen Winkelabschnitt von 30° die Beschichtungszeit T_{B} verlängert wird, was zu unerwünschten Schichtdicken führt. Dadurch wird die Qualität der Beschichtung verändert. Bei vorzeitiger Unterbrechung der Beschichtung durch Abkürzung beider Phasen würde es zu instabilen Druck-Fluss-Verhältnissen in den Behandlungseinrichtungen (101,102,...,112) kommen. Deshalb wird der Behandlungseinrichtung (101) über den gesamten Winkelabschnitt von 30° das Prozessgas zugeführt, jedoch der Winkelabschnitt für die Prozessphase -"*Zünden Plasma Haftvermittler* (E)"- in Abhängigkeit von der aktuellen Drehgeschwindigkeit des Rundläufers ermittelt und innerhalb der Prozessphase -"*Zuführen Prozessgas* Haftvermittler (D)"- variabel eingestellt, so dass bei Verlangsamung des Rundläufers der Winkelabschnitt entsprechend verkürzt wird und eine konstante Beschichtungszeit T_{B} realisiert wird. Dabei wird der Winkelabschnitt (E) dieser Prozessphase in Abhängigkeit von der aktuellen Drehgeschwindigkeit des Rundläufers so eingestellt, dass er vollständig von dem vorgegebenen Winkelabschnitt von 30° überdeckt wird, der für eine maximale Drehgeschwindigkeit definiert ist. Außerdem ergibt sich zumindest eine Leerphase für den Prozeß der Plasmazündung. Dabei kann eine Leerphase auf die Prozessphase (E) folgen und/oder dieser vorangehen. Das Ventil (503) für die Steuerung der Prozessgaszufuhr des Haftvermittlers bleibt während des Durchlaufens des festen Winkelabschnittes der Prozessphase -"*Zuführen Prozessgas* Haftvermittler (D)"-, also auch während einer Leerphase für den Prozeß der Plasmazündung, geöffnet und die Zündung des Plasmas erfolgt entsprechend dem ermittelten variablen Winkelabschnitt. Dabei kann die Zündung unmittelbar nach einer kurzen Verzögerungszeit t_{verz} nach der Gaszufuhr beginnen und gleichzeitig mit dieser enden oder auch später beginnen und früher enden. Eine entsprechende Steuerung erfolgt über die Steuereinrichtung (200).

Anschließend wechselt die Behandlungseinrichtung (101) in den zweiten Beschichtungsprozess, welcher die Prozessphasen -"*Zuführen Prozessgas Barriereschicht (F)"-* und -"*Zünden Plasma Barriereschicht* (G)"- umfasst. Die Einstellung der Winkelabschnitte erfolgt analog zu der des ersten Beschichtungsprozesses, wobei der feste Winkelabschnitt für die Prozessphase -"*Zuführen Prozessgas Barriereschicht* (F)" - beispielsweise 120° beträgt. Außerdem ist es vorteilhaft, wenn im letzten Beschichtungsprozess beide Phasen gemeinsam enden, da so kein Prozessgas im Hohlkörper (1,2) verbleibt.

Die beiden letzten Prozessphasen -"*Belüften* (H)"- und - "*Entfernen* der Hohlkörper (I)"- erfolgen in festen Winkelabschnitten gemäß Fig. 1.

Dabei ist das Belüften in die zeitlich versetzen, aber zum Teil parallel ablaufenden Teilschritte -"Belüften des Innenraums der Hohlkörper (H1)"- und -"Belüften der Behandlungseinrichtung (H2)"- unterteilt. Dabei wird zunächst der Innenraum der Flasche belüftet und nach einer festen Verzögerungszeit t_{verz} die Behandlungseinrichtung belüftet. Der Ablauf erfolgt derart, dass unabhängig von der Drehgeschwindigkeit der Maschine immer eine gleichbleibende Verzögerungszeit zwischen den Teilschritten verwendet wird.

Während der Belüftung kann der Hohlkörper (1,2) außerdem mit einem Spülgas gespült werden, welches durch öffnen des Ventils (503) bereitgestellt wird.

Ein kontinuierlicher Ablauf ist auch dann gegeben, wenn durch ein anderes Konzept bedingt, eine oder mehrere Behandlungseinrichtung (101,102,...,112) ohne Hohlkörper alle Prozessphasen (A,B,...,I) durchlaufen.

Die hier ausgeführte Beschichtung ist ebenso für eine Aussen- und/oder Innenbeschichtungen durchführbar. Für eine Außenbeschichtung wären die Prozessabläufe derart vertauscht, dass die Gase in den Außenraum geleitet werden und in diesem Bereich das Plasma gezündet wird während im Innenraum durch einen geeigneten Druck das Zünden eines Plasmas verhindert wird.

Der beispielhaft beschriebene Barrierebeschichtungsprozess von PET-Flaschen ist stabil gegen Parameterschwankungen und Prozesszeitschwankungen bis ca. 10 %, wobei ein O₂-BIF-Wert von mindestens 1,5 , vorzugsweise sogar von mehr als 10 erreicht wird. Dieser Sauerstoff-Barriere-Verbesserungsfaktor (O₂-BIF) wird beispielsweise für PET-Flaschen erreicht, die ohne Beschichtung eine Sauerstoff-Fermeation von 0,20 cm³/(Pck d bar) und mit Barrierebeschichtung eine um einen Faktor größer als Zehn reduzierte Sauerstoff-Permeation aufweisen.

### Bezugszeichenliste:

- A: Einbringen der Hohlkörper
- B: Evakuierung der Behandlungseinrichtung
- C: Evakuierung der Hohlkörper
- D: Zuführen Prozessgas Haftvermittler
- E: Zünden Plasma Haftvermittler
- F: Zuführen Prozessgas Barriereschicht
- G: Zünden Plasma Barriereschicht
- H1: Belüften des Innenraums der Hohlkörper
- H2: Belüften der Behandlungseinrichtung
- I: Entfernen der Hohlkörper

- 1 bis 24: Substrat/Hohlkörper
- 101 bis 112: Behandlungseinrichtung
- 200: Steuereinrichtung
- 31: Verteilerleitung erste Pumpeinrichtung
- 32: Verteilerleitung zweite Pumpeinrichtung
- 301: erste Pumpeinrichtung
- 302: zweite Pumpeinrichtung
- 41: Verteilerleitung Prozessgas Haftvermittler
- 42: Verteilerleitung Prozessgas Barriereschicht
- 43: Verteilerleitungen Spülgas
- 401: Prozessgasversorgungseinrichtung Haftvermittler
- 402: Prozessgasversorgungseinrichtung Barriereschicht
- 403: Prozessgasversorgungseinrichtung Spülgas
- 501 bis 536: Ventile zur Steuerung der Gaszufuhr
- 601 bis 624: Ventile zur Steuerung der Evakuierung

## Patentansprüche

1. Verfahren zum Behandeln von Substraten, bei welchem
- in mehreren, auf einem Rundläufer befindlichen Behandlungseinrichtungen jede Behandlungseinrichtung eine Mehrzahl von Prozessphasen eines Behandlungszyklus während einer Umdrehung des Rundläufers durchläuft,
- in Abhängigkeit von der Winkelposition einer Behandlungseinrichtung die Steuerung der Prozeßphasen in dieser Behandlungseinrichtung erfolgt und
- ein Behandlungszyklus zumindest die folgenden Prozessphasen umfasst:
- Einbringen zumindest eines Substrates in eine Behandlungseinrichtung,
- Behandeln zumindest eines Substrates in einer Behandlungseinrichtung und
- Entfernen der/des behandelten Substrates aus der Behandlungseinrichtung,
**dadurch gekennzeichnet, dass**
zumindest ein Winkelabschnitt einer Prozessphase in Abhängigkeit von der aktuellen Drehgeschwindigkeit des Rundläufers innerhalb eines vorgegebenen Winkelabschnittes, der für eine maximale Drehgeschwindigkeit definiert ist, eingestellt wird.

2. Verfahren nach Anspruch 1, **dadurch gekennzeichnet, dass** ein Behandlungszyklus zumindest die folgenden Prozessphasen umfasst:
- Einbringen zumindest eines Substrates in eine Behandlungseinrichtung,
- Plasmabehandlung zumindest eines Substrates in einer Behandlungseinrichtung und
- Entfernen der/des behandelten Substrates aus der Behandlungseinrichtung.

3. Verfahren nach Anspruch 2, **dadurch gekennzeichnet, dass** ein Behandlungszyklus zumindest die folgenden Prozessphasen umfasst:
- Einbringen zumindest eines Substrates in eine Behandlungseinrichtung,
- Evakuierung der für eine Beschichtung erforderlichen Räume in der Behandlungseinrichtung,
- Zuführen von Prozessgas,
- Zünden eines Plasmas, wobei eine Beschichtung des Substrates erfolgt und
- Entfernen der/des behandelten Substrates aus der Behandlungseinrichtung.

4. Verfahren nach Anspruch 3, **dadurch gekennzeichnet, dass** der Winkelabschnitt der Prozessphase - Zünden eines Plasmas - in Abhängigkeit von der aktuellen Drehgeschwindigkeit des Rundläufers innerhalb des Winkelabschnittes der Prozessphase
- Zuführen von Prozessgas - eingestellt wird, wobei die Dauer für die Prozessphase - Zünden eines Plasmas
- für jede Behandlungseinrichtung gleich ist.

5. Verfahren nach einem der Ansprüche 3 oder 4, **dadurch gekennzeichnet, dass** ein Behandlungszyklus mehrere Beschichtungsvorgänge mit unterschiedlichen Beschichtungen umfasst.

6. Verfahren nach einem der Ansprüche 3 bis 5, **dadurch gekennzeichnet, dass** der Winkelabschnitt für die Prozessphase - Zünden eines Plasmas - so eingestellt wird, dass die Winkelposition für das Ende der Prozessphase - Zünden eines Plasmas - für zumindest den letzten Beschichtungsvorgang eines Behandlungszyklus der Winkelposition für das Ende der Prozessphase - Zuführen von Plasma - entspricht.

7. Verfahren nach einem der vorhergehenden Ansprüche, **dadurch gekennzeichnet, dass** ein Hohlkörper behandelt wird.

8. Verfahren nach einem der vorhergehenden Ansprüche, **dadurch gekennzeichnet, dass** ein Kunststoff-Hohlkörper mit einer Barriereschicht von innen und/oder außen beschichtet wird.

9. Verfahren nach Anspruch 8, **dadurch gekennzeichnet, dass** ein Behandlungszyklus zumindest die folgenden Prozessphasen umfasst:
- Einbringen zumindest eines Hohlkörpers in eine Behandlungseinrichtung,
- Evakuierung der Behandlungseinrichtung im Bereich des Außenraumes des Hohlkörpers bis zu einem ersten Druckwert,
- Evakuierung des Innenraumes des Hohlkörpers bis zu einem zweiten Druckwert, welche niedriger ist als der erste Druckwert,
- Zuführen eines ersten Prozessgases für eine Haftvermittlerschicht,
- Zünden eines Plasmas, wobei die Beschichtung des Hohlkörpers mit einer Haftvermittlerschicht erfolgt,
- Zuführen eines zweiten Prozessgases für eine Barriereschicht,
- Zünden eines Plasmas, wobei die Beschichtung des Hohlkörpers einer Barriereschicht erfolgt,
- Belüften der Behandlungseinrichtung und des Hohlkörpers und
- Entfernen der/des beschichteten Hohlkörpers aus der Behandlungseinrichtung.

10. Verfahren nach Anspruch 9, **dadurch gekennzeichnet, dass** die Winkelposition zum Start der Prozessphase - Evakuierung des Innenraumes des Hohlkörpers bis zu einem zweiten Druckwert - in Abhängigkeit von der aktuellen Drehgeschwindigkeit des Rundläufers variabel zur Winkelposition zum Start der Prozessphase - Evakuierung der Behandlungseinrichtung im Bereich des Außenraumes des Hohlkörpers bis zu einem ersten Druckwert - eingestellt wird, so dass eine feste Verzögerungszeit zwischen diesen Prozessphasen realisiert wird.

11. Verfahren einem der Ansprüche 3 bis 10, **dadurch gekennzeichnet, dass** die Behandlungseinrichtungen und/oder Hohlkörper mittels zumindest einer gemeinsamen Pumpeinrichtung phasenweise evakuiert werden, wobei die Verbindung der Pumpeinrichtung mit den einzelnen Behandlungsstationen über Verteilerleitungen hergestellt wird und eine Steuerung der Evakuierung über Ventile erfolgt.

12. Verfahren nach Anspruch 11, **dadurch gekennzeichnet, dass** die zumindest eine Pumpeinrichtung auf dem Rundläufer mitrotiert.

13. Verfahren nach einem der Ansprüche 2 bis 12, **dadurch gekennzeichnet, dass** den Behandlungseinrichtungen mittels zumindest einer gemeinsamen Prozessgasversorgungseinrichtung das Prozessgas zugeführt wird, wobei die Verbindung der Prozessgasversorgungseinrichtung mit den einzelnen Behandlungsstationen über Verteilerleitungen hergestellt wird und eine Steuerung der Prozessgaszufuhr über Ventile erfolgt.

14. Verfahren nach Anspruch 10, **dadurch gekennzeichnet, dass** den Behandlungseinrichtungen verschiedene Prozessgase mit jeweils gesonderten gemeinsamen Prozessgasversorgungseinrichtung zugeführt werden.

15. Verfahren nach einem der Ansprüche 2 bis 14, **dadurch gekennzeichnet, dass** das Zünden eines Plasmas mittels Mikrowellenenergie erfolgt.

16. Verfahren nach Anspruch 15, **dadurch gekennzeichnet, dass** das Zünden des Plasmas mittels gepulster Mikrowellenenergie erfogt.

17. Verfahren nach einem der vorhergehenden Ansprüche, **dadurch gekennzeichnet, dass** im kontinuierlichen Verfahrensablauf permanent jede Behandlungseinrichtung mit zumindest einem Substrat zumindest eine Prozessphase durchläuft und jede Behandlungseinrichtung alle Prozessphasen durchläuft, wobei eine Behandlungseinrichtung in eine Prozessphase der vorgeordneten Behandlungseinrichtung wechselt.

18. Verfahren nach einem der vorhergehänden Ansprüche, vorzugsweise nach Anspruch 11 und 13, **dadurch gekennzeichnet, dass** vor dem Einbringen des ersten Substrates in eine Behandlungseinrichtung beim Starten eines kontinuierlichen Verfahrensablaufes jede Behandlungseinrichtung ohne Substrat jede Prozessphase zumindest einmal durchläuft, wobei die Zündung des Plasmas entfällt.

19. Verfahren gemäß einem der vorstehenden Ansprüche,
**dadurch gekennzeichnet, dass** ein Winkelabschnitt
einer Prozessphase in Abhängigkeit von der aktuellen Drehgeschwindigkeit des Rundläufers so eingestellt wird, dass er vollständig von einem jeweiligen vorgegebenen Winkelabschnittes überdeckt wird, der für eine maximale Drehgeschwindigkeit definiert ist.

20. Verfahren gemäß einem der vorstehenden Ansprüche, **dadurch gekennzeichnet, dass** die Winkelabschnitte mehrerer aufeinanderfolgender Prozessphasen bei nicht maximaler Drehgeschwindigkeit so eingestellt werden, dass zwischen diesen Phasen eine Leerphase entsteht.

21. Vorrichtung zum Behandeln von Substraten (1,2,...,24), insbesondere mit einem Verfahren gemäß einem der vorstehenden Ansprüche, mit mehreren, auf einem Rundläufer befindlichen Behandlungseinrichtungen (101,102,...,112), welche eine Mehrzahl von Prozessphasen (A,B,...,I) eines Behandlungszyklus während einer Umdrehung des Rundläufers durchlaufen, wobei jeder Prozessphase (A,B,...,I) ein Winkelbereich des Rundläufers zugeordnet ist und der Rundläufer zumindest die folgenden Winkelbereiche umfasst:
- Bereich zum Einbringen zumindest eines Substrates (1,2,...,24) in eine Behandlungseinrichtung (101,102,...,112),
- Bereich zum Behandeln zumindest eines Substrates (1,2,...,24) in einer Behandlungseinrichtung (101,102,...,112) und
- Bereich zum Entfernen der/des behandelten Substrates (1,2,...,24) aus der Behandlungseinrichtung (101,102,...,112), **gekennzeichnet durch** eine Steuereinrichtung (200) zum Einstellen zumindest eines Winkelabschnittes in Abhängigkeit von der aktuellen Drehgeschwindigkeit des Rundläufers innerhalb des vorgegebenen Winkelbereiches, der für eine maximale Drehgeschwindigkeit definiert ist.

22. Vorrichtung nach Anspruch 21, **dadurch gekennzeichnet, dass** der Rundläufer zumindest die folgenden Winkelbereiche umfasst:
- Bereich zum Einbringen zumindest eines Substrates (1,2,...,24) in eine Behandlungseinrichtung (101,102,...,112),
- Bereich zur Plasmabehandlung zumindest eines Substrates(1,2,...,24) in einer Behandlungseinrichtung (101,102,...,112) und
- Bereich zum Entfernen der/des behandelten Substrates (1,2,...,24) aus der Behandlungseinrichtung (101,102,...,112).

23. Vorrichtung nach Anspruch 22, **dadurch gekennzeichnet, dass** der Rundläufer zumindest die folgenden Winkelbereiche umfasst:
- Bereich zum Einbringen zumindest eines Substrates (1,2,...,24) in eine Behandlungseinrichtung (101,102,...,112),
- Bereich zum Evakuierung der für eine Beschichtung erforderlichen Räume in der Behandlungseinrichtung (101,102,...,112), - Bereich zum Zuführen von Prozessgas,
- Bereich zum Zünden eines Plasmas, wobei eine Beschichtung des Substrates (1,2,...,24) erfolgt und
- Bereich zum Entfernen der/des behandelten Substrates (1,2,...,24) aus der Behandlungseinrichtung (101,102,...,112).

24. Vorrichtung nach einem der vorhergehenden Ansprüche, **dadurch gekennzeichnet, dass** das Substrat (1,2,...,24) ein Hohlkörper ist.

25. Vorrichtung nach einem der vorhergehenden Ansprüche, **dadurch gekennzeichnet, dass** das Substrat (1,2,...,24) ein Kunststoff-Hohlkörper ist.

26. Vorrichtung nach Anspruch 25, **dadurch gekennzeichnet, dass** der Rundläufer zumindest die folgenden Winkelbereiche umfasst:
- Bereich zum Einbringen zumindest eines Hohlkörpers (1,2,...,24) in eine Behandlungseinrichtung (101,102,...,112),
- Bereich zum Evakuierung der Behandlungseinrichtung (101,102,...,112) bis zu einem ersten Druckwert,
- Bereich zum Evakuierung des Innenraumes des Hohlkörpers (1,2,...,24) bis zu einem zweiten Druckwert, welcher niedriger ist als der erste Druckwert,
- Bereich zum Zuführen eines ersten Prozessgases für eine Haftvermittlerschicht,
- Bereich zum Zünden eines Plasmas, wobei die Beschichtung des Hohlkörpers (1,2,...,24) von innen mit einer Haftvermittlerschicht erfolgt,
- Bereich zum Zuführen eines zweiten Prozessgases für eine Barriereschicht,
- Bereich zum Zünden eines Plasmas, wobei die Beschichtung des Hohlkörpers (1,2,...,24) von innen mit einer Barriereschicht erfolgt,
- Bereich zum Belüften der Behandlungseinrichtung (101,102,...,112) und
- Bereich zum Entfernen der/des beschichteten Hohlkörpers (1,2,...,24) aus der Behandlungseinrichtung (101,102,...,112).

27. Vorrichtung einem der Ansprüche 23 bis 26, **dadurch gekennzeichnet, dass** die Behandlungseinrichtungen (101,102,...,112) über Verteilerleitungen (301,302) mit zumindest einer gemeinsamen Pumpeinrichtung (31,32) verbunden sind und die Verteilerleitungen (301,302) Ventile (601,602,...624) zur Steuerung der Evakuierung der Behandlungseinrichtung (101,102,...,112)aufweisen.

28. Vorrichtung nach Anspruch 27, **dadurch gekennzeichnet, dass** die zumindest eine Pumpeinrichtung (31,32) auf dem Rundläufer angeordnet ist.

29. Vorrichtung nach einem der Ansprüche 23 bis 28, **dadurch gekennzeichnet, dass** die Behandlungseinrichtungen (101,102,...,112) über Verteilerleitungen (41,42,43) mit zumindest einer gemeinsamen Prozessgasversorgungseinrichtung (401,402,403) verbunden sind und die Verteilerleitungen (41,42,43) Ventile (501,502,...,536) zur Steuerung der Prozessgaszufuhr aufweisen.

30. Vorrichtung nach Anspruch 29, **dadurch gekennzeichnet, dass** für jedes Prozessgas eine gesonderte gemeinsame Prozessgasversorgungseinrichtung (401,402,403) mit den Behandlungseinrichtungen (101,102,...,112) verbunden ist.

31. Vorrichtung nach einem der Ansprüche 23 bis 30, **dadurch gekennzeichnet, dass** die Behandlungseinrichtungen (101,102,...,112) Einrichtungen zum Zünden eines Plasmas mittels Mikrowellenenergie aufweisen.

32. Vorrichtung nach Anspruch 31, **dadurch gekennzeichnet**, die Behandlungseinrichtungen (101,102,...,112) Einrichtungen zum gepulsten Zünden eines Plasmas mittels Mikrowellenenergie aufweisen.

33. Vorrichtung gemäß einem der vorstehenden Ansprüche, **dadurch gekennzeichnet, dass** die Steuereinrichtung eingerichtet ist, einen Winkelabschnitt einer Prozessphase in Abhängigkeit von der aktuellen Drehgeschwindigkeit des Rundläufers so einyustellen, dass er vollständig von einem jeweiligen vorgegebenen Winkelabschnittes überdeckt wird, der für eine maximale Drehgeschwindigkeit definiert ist.

34. Vorrichtung gemäß einem der vorstehenden Ansprüche, **dadurch gekennzeichnet, dass** die Steuereinrichtung eingerichtet ist, die Winkelabschnitte mehrerer aufeinanderfolgender Prozessphasen bei nicht maximaler Drehgeschwindigkeit so einzustellen, dass zwischen diesen Phasen eine Leerphase entsteht.
